# EUROPEAN PATENT APPLICATION

(11) **EP 1 681 715 A1**
(43) Date of publication of application: **19.07.2006**
(21) Application number: 04818177.0
(22) Date of filing: 02.11.2004
(51) Int. Cl.: H01L 21/31, H01L 21/3065

(54) **PLASMA PROCESSING APPARATUS**

(30) Priority: 05.11.2003 JP 2003375437
(71) Applicant: OHMI, Tadahiro, Sendai-shi, Miyagi 980-0813 (JP); TOKYO ELECTRON LIMITED, Minato-ku, Tokyo 107-8481 (JP)
(72) Inventor: OHMI, Tadahiro, Sendai-Shi, Miyagi 9800813 (JP); NOZAWA, Toshihisa, c/o TOKYO ELECTRON AT LIMITED, Amagasaki-Shi, Hyogo 6600891 (JP); MORITA, Osamu, c/o TOKYO ELECTRON AT LIMITED, Amagasaki-Shi, Hyogo 6600891 (JP); YUASA, Tamaki, c/o TOKYO ELECTRON AT LIMITED, Amagasaki-Shi, Hyogo 6600891 (JP); KOTANI, Koji, c/o TOKYO ELECTRON AT LIMITED, Amagasaki-Shi, Hyogo 6600891 (JP)
(74) Representative: HOFFMANN EITLE
(86) International application number: PCT/JP2004/016252
(87) International publication number: WO 2005/045913

(57) **Abstract**

The present invention has an object of improving the cooling efficiency of the process gas supply part of a plasma processor and thereby suppressing an increase in the temperature of the process gas supply part.

Therefore, used in the present invention is a plasma processor having a processing vessel having a holder holding a substrate to be processed, a microwave antenna provided on the processing vessel so as to oppose the substrate to be processed, and a processing gas supply part provided between the substrate to be processed on the holder and the microwave antenna so as to oppose the substrate to be processed, **characterized in that** the process gas supply part has multiple first openings through which plasma formed in the processing vessel passes, a process gas channel connectable to a process gas source, multiple second openings communicating with the process gas channel, and a cooling medium channel through which a cooling medium cooling the process gas supply part flows, wherein the cooling medium includes mist.

## Description

### TECHNICAL FIELD

The present invention relates generally to plasma processors, and more particularly to a microwave plasma processor.

The plasma processing process and plasma processors are technologies indispensable for manufacturing recent ultrafine semiconductor devices having a gate length of approximately or not more than 0.1 µm, so-called deep submicron devices or deep sub-quarter micron devices, and for manufacturing high-resolution flat display units including liquid crystal display units.

A variety of conventional plasma excitation methods have been employed for plasma processors used in manufacturing semiconductor devices and liquid crystal display units, among which parallel-plate high-frequency excitation plasma processors (capacitively coupled plasma processors) or inductively coupled plasma processors are common in particular. However, these conventional plasma processors have a problem in that it is difficult to perform a uniform process over the entire surface of a substrate to be processed at high processing speed or throughput because plasma formation is non-uniform so that an area of high electron density is limited. This problem becomes serious in the case of processing a large-diameter substrate in particular. Further, these conventional plasma processors have inherent problems. For example, because of high electron temperature, a semiconductor device formed on a substrate to be processed is damaged and the substrate is contaminated heavily with metal due to sputtering of the chamber wall. Accordingly, it is becoming difficult for the conventional plasma processors to satisfy severe requirements for further miniaturization of semiconductor devices and liquid crystal display units and for further improvement in productivity.

On the other hand, conventionally, a microwave plasma processor using high-density plasma excited by a microwave electric field without using a direct current magnetic field is proposed. For example, a plasma processor is proposed wherein a microwave is radiated into a processing vessel from a plane antenna having multiple slots arranged so as to generate a uniform microwave (a radial line slot antenna) so that plasma is excited by ionizing gas in the vacuum vessel with this microwave electric field.

According to microwave plasma excited by such a method, it is possible to achieve high plasma density over a wide area immediately below the antenna, so that uniform plasma processing can be performed in a short period of time. Further, in the microwave plasma formed by such a method, electron temperature is low because the plasma is excited by a microwave, so that it is possible to avoid damaging a substrate to be processed and metal contamination. Further, since it is also possible to excite plasma evenly on a large-area substrate with ease, it is also possible to support a manufacturing process of semiconductor devices using a large-diameter semiconductor substrate and manufacture of large liquid crystal display units with ease.

### BACKGROUND ART

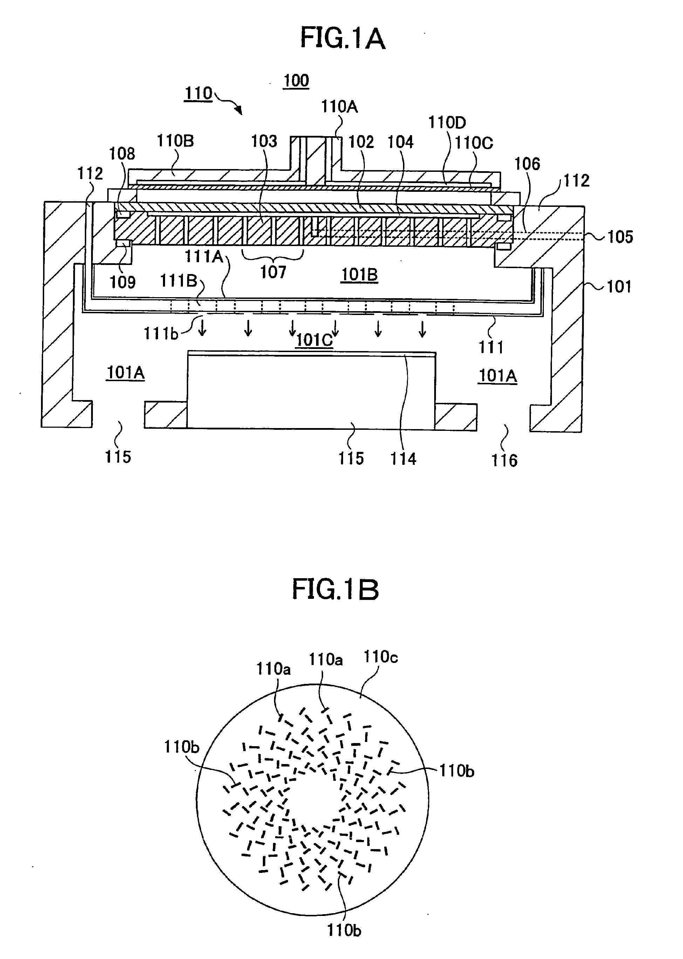

FIGS. 1A and 1B show a conventional microwave plasma processor 100 using such a radial line slot antenna. FIG. 1A is a cross-sectional view of the microwave plasma processor 100, and FIG. 1B is a diagram showing a configuration of the radial line slot antenna.

Referring to FIG. 1A, the microwave plasma processor 100 has a processing chamber 101 evacuated through multiple exhaust ports 116. A holder 115 holding a substrate to be processed 114 is formed in the processing chamber 101. In order to realize even evacuation of the processing chamber 101, a space 101A is formed annularly around the holder 115. Forming the exhaust ports 116 at equal intervals, that is, axially symmetrically with respect to the substrate to be processed, so as to communicate with the space 101A makes it possible to evenly evacuate the processing chamber 101 through the space 101A and the exhaust ports 116.

A plate-like shower plate 103 formed of a dielectric plate with low dielectric loss of microwave and having multiple openings 107 formed therein is formed through a seal ring 109 on the processing chamber 101 at a position corresponding to the substrate to be processed 114 on the holder 115 as part of the exterior wall of the processing chamber 101. A cover plate 102 also formed of a dielectric plate with low dielectric loss of microwave is formed through another seal ring 108 on the outside of the shower plate 103.

A plasma gas channel 104 is formed on the upper surface of the shower plate 103. Each of the openings 107 is formed so as to communicate with the plasma gas channel 104. Further, a plasma gas supply channel 106 communicating with a plasma gas supply port 105 formed on the exterior wall of the processing vessel 101 is formed inside the shower plate 103. A plasma gas of Ar, Kr, etc., supplied to the plasma gas supply port 105 is supplied from the supply channel 106 to the openings 107 through the channel 104 so as to be emitted with substantially uniform density from the openings 107 into a space 101B immediately under the shower plate 103 inside the processing vessel 101.

On the processing vessel 101, a radial line slot antenna 110 having a radiation surface shown in FIG. 1B is further provided external to the cover plate 102. The radial line slot antenna 110 is connected to an external microwave source (not graphically illustrated) through a coaxial waveguide 110A so as to excite the plasma gas emitted into the space 101B with a microwave from the microwave source. The gap between the cover plate 102 and the radiation surface of the radial line slot antenna 110 is filled with air.

The radial line slot antenna 110 is composed of a flat disk-like antenna main body 110B connected to the outer waveguide of the coaxial waveguide 110A and a radiation plate 110C formed in the opening of the antenna main body 110B. Multiple slots 110a and multiple slots 110b perpendicular thereto shown in FIG. 1B are formed in the radiation plate 110C. A dielectric plate 110D formed of a dielectric plate of uniform thickness is interposed between the antenna main body 110B and the radiation plate 110C.

In the radial line slot antenna 110 of this configuration, a microwave fed from the coaxial waveguide 110A travels between the disk-like antenna main body 110B and the radiation plate 110C so as to spread radially, when the wavelength of the microwave is compressed by the action of the dielectric plate 110D. Therefore, forming the slots 110a and 110b concentric with and perpendicular to each other in response to the wavelength of the microwave traveling axially makes it possible to radiate a plane wave having circular polarization in a direction substantially perpendicular to the radiation plate 110C.

By using this radial line slot antenna 110, uniform high-density plasma is formed in the space 101B immediately under the shower plate 103. The high-density plasma thus formed has low electron temperature. Accordingly, the substrate to be processed 114 is prevented from being damaged, and the wall of the processing vessel 101 is free of metal contamination due to sputtering.

In the plasma processor 100 of FIG. 1A, further, a process gas supply part 111 formed of a conductor is provided between the shower plate 103 and the substrate to be processed 114 in the processing vessel 101. A process gas channel 111B communicating with a process gas channel 112 connected to an external gas source (not graphically illustrated) and formed in the processing vessel 101 is formed inside the process gas supply part 111. Multiple gas holes 111b communicating with the process gas channel 111B are formed in the process gas supply part 111. Each of the gas holes 111b emits a supplied process gas to a space 101C between the process gas supply part 111 and the substrate to be processed 114.

An opening 111A sized so as to let plasma formed in the space 101B pass through from the space 101B to the space 101C efficiently by diffusion is formed between corresponding adjacent ones of the gas holes 111b in the process gas supply part 111.

When the process gas is thus emitted from the process gas supply part 111 to the space 101C through the gas holes 111b, the emitted process gas is excited by the high-density plasma formed in the space 101B.

However, the plasma processor 100 of FIG. 1A has a problem in that the temperature of the process gas supply part 111 increases because of its exposure to a large amount of heat flux due to the high-density plasma. Therefore, it has been proposed to suppress an increase in the temperature of the process gas supply part by providing, for example, a refrigerant channel in the process gas supply part (see, for example, Patent Document 1).
Patent Document 1: WO02/080249A1

### DISCLOSURE OF THE INVENTION

### PROBLEMS TO BE SOLVED BY THE INVENTION

However, in the case of, for example, cooling the process gas supply part 111 by providing a refrigerant channel therein, cooling efficiency is insufficient for the amount of heat input to the process gas supply part by a large amount of heat flux due to the high-density plasma. This results in insufficient suppression of an increase in the temperature of the process gas supply part, thus causing a problem in that the temperature of the process gas supply part increases.

Further, use of a refrigerant for cooling increases the running costs of a plasma processor, thus causing a problem in that the productivity of the plasma processor decreases.

Accordingly, an object of the present invention is to provide a novel and useful plasma processor in which the above-described problems are solved.

A specific object of the present invention is to provide a plasma processor in which the cooling efficiency of the process gas supply part of the plasma processor is improved so that an increase in the temperature of the process gas supply part is suppressed.

Another object of the present invention is to reduce the cost of cooling the process gas supply part of the plasma processor and thereby to reduce the running costs of the plasma processor.

### MEANS OF SOLVING THE PROBLEMS

According to a first aspect of the present invention, the above objects are achieved by a plasma processor having a processing vessel having a holder holding a substrate to be processed, a microwave antenna provided on the processing vessel so as to oppose the substrate to be processed, and a processing gas supply part provided between the substrate to be processed on the holder and the microwave antenna so as to oppose the substrate to be processed, characterized in that the process gas supply part has multiple first openings through which plasma formed in the processing vessel passes, a process gas channel connectable to a process gas source, multiple second openings communicating with the process gas channel, and a cooling medium channel through which a cooling medium cooling the process gas supply part flows, wherein the cooling medium includes a cooling gas and mist.

According to a second aspect of the present invention, the above objects are achieved by a plasma processor having a processing vessel having a holder holding a substrate to be processed, a microwave antenna provided on the processing vessel so as to oppose the substrate to be processed, and a processing gas supply part provided between the substrate to be processed on the holder and the microwave antenna so as to oppose the substrate to be processed, characterized in that the process gas supply part has multiple first openings through which plasma formed in the processing vessel passes, a process gas channel connectable to a process gas source, multiple second openings communicating with the process gas channel, and a cooling medium channel through which a cooling medium cooling the process gas supply part flows, wherein a cooling medium circulator circulating the cooling medium is connected to the cooling medium channel.

### EFFECTS OF THE INVENTION

According to the present invention, in a plasma processor using microwave plasma, it is possible to increase the cooling efficiency of the process gas supply part of the plasma processor and thereby to suppress an increase in the temperature of the process gas supply part.

Further, it is possible to reduce the cost of cooling the process gas supply part of the plasma processor and thereby to reduce the running costs of the plasma processor.

### BRIEF DESCRIPTION OF THE DRAWINGS

[FIG. 1A] is a diagram showing a configuration of a conventional microwave plasma processor.
[FIG. 1B] is a plan view showing a slot plate used in the plasma processor of FIG. 1A.
[FIG. 2] is a diagram showing a configuration of a microwave plasma processor according to a first embodiment.
[FIG. 3] is a plan view showing a slot plate used in the plasma processor of FIG. 2.
[FIG. 4A] is a (first) cross-sectional view of a process gas supply part used in the plasma processor of FIG. 2.
[FIG. 4B] is a (second) cross-sectional view of the process gas supply part used in the plasma processor of FIG. 2.
[FIG. 4C] is a cross-sectional view of the process gas supply part of FIG. 4B.
[FIG. 5A] is a (first) diagram showing a method of manufacturing the process gas supply part step by step.
[FIG. 5B] is a (second) diagram showing the method of manufacturing the process gas supply part step by step.
[FIG. 5C] is a (third) diagram showing the method of manufacturing the process gas supply part step by step.
[FIG. 6] is a (first) diagram showing a variation of the plasma processor of FIG. 2.
[FIG. 7] is a (second) diagram showing a variation of the plasma processor of FIG. 2.
[FIG. 8] is a diagram showing a variation of the plasma processor of FIG. 7.

### BEST MODE FOR CARRYING OUT THE INVENTION

Next, a description is given of embodiments of the present invention.

### First Embodiment

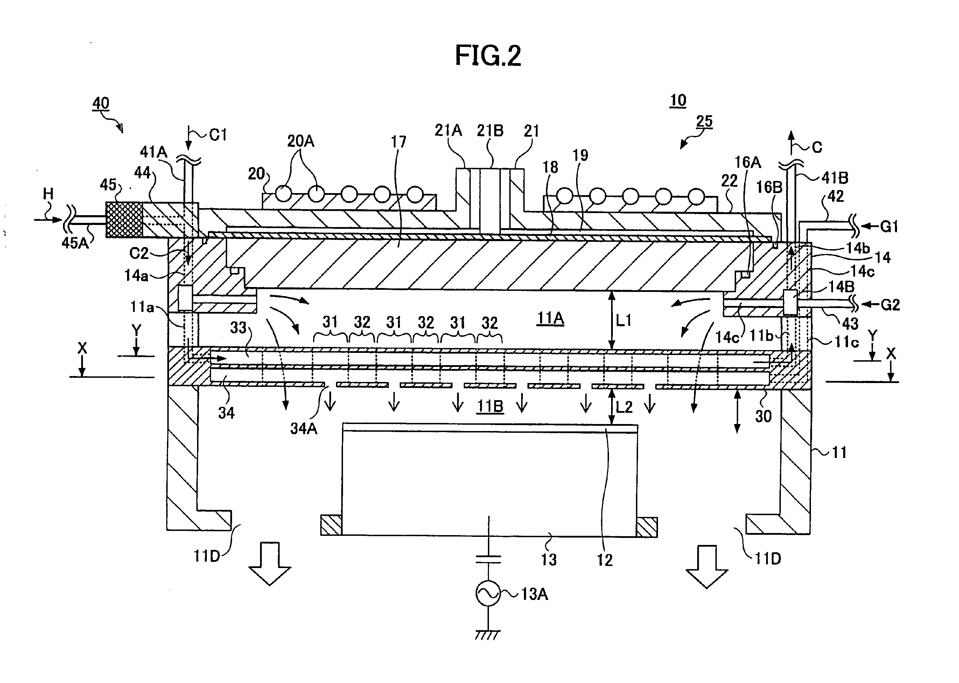

FIG. 2 schematically shows a configuration of a plasma processor 10 according to a first embodiment of the present invention.

Referring to FIG. 2, the plasma processor 10 has a processing vessel 11 evacuated through multiple exhaust ports 11D and a holder 13 provided in the processing vessel 11 and holding a substrate to be processed 12 with an electrostatic chuck. A heater, not graphically illustrated, is embedded in the holder 13.

The processing vessel 11 is preferably formed of austenitic stainless steel including Al. A protection film of aluminum oxide is formed on the wall surface of the processing vessel 11 by oxidation. Further, a microwave transmission window 17 transmitting a microwave is provided in a part of the exterior wall of the processing vessel 11 corresponding to the substrate to be processed 12, and a plasma gas introduction ring 14 introducing a plasma gas is interposed between the microwave transmission window 17 and the processing vessel 11, each forming the exterior wall of the processing vessel.

The peripheral edge part of the microwave transmission window 17 includes a step-like shape. The step-like shape part engages a step-like shape provided in the plasma gas introduction ring 14 so that air tightness inside the processing vessel 11 is retained further with a seal ring 16A.

A gas introduction part 43 is connected to the plasma gas introduction ring. A plasma gas of, for instance, Ar is introduced from the gas introduction part 43. The plasma gas diffuses in a gas groove 14B formed substantially annularly inside the gas introduction ring 14. The plasma gas in the gas groove 14B is supplied from multiple plasma gas holes 14C communicating with the gas groove 14B to a processing space 11A between a process gas supply part 30 described below and the microwave transmission window 17.

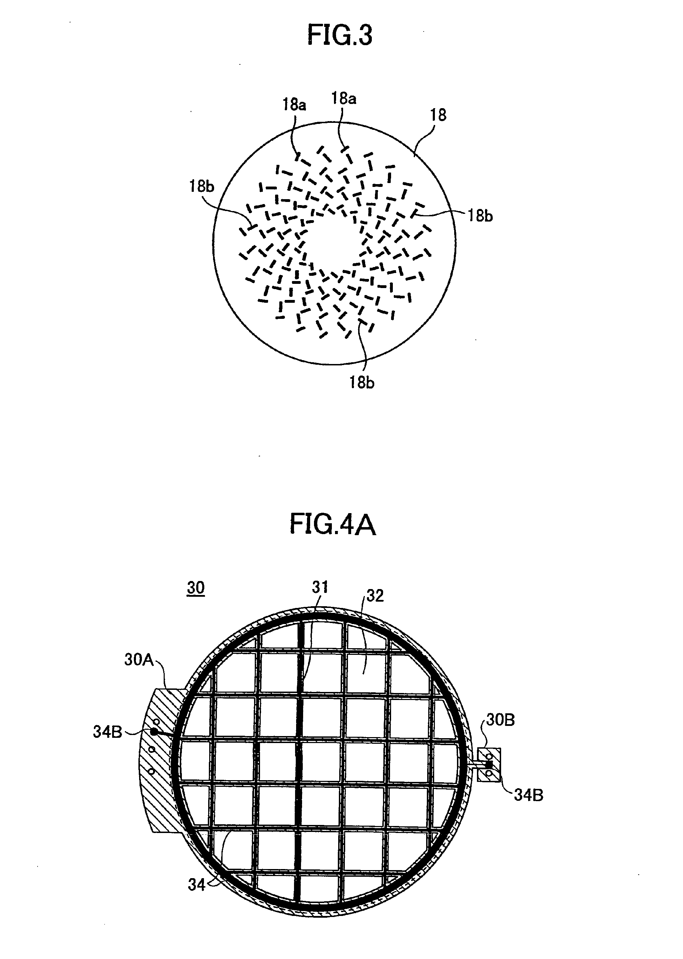

On the microwave transmission window 17 is provided a radial line slot antenna 25 composed of a disk-like slot plate 18 contacting the microwave transmission window 17 closely and having multiple slots 18a and 18b shown in FIG. 3 formed therein, a disk-like antenna main body 22 holding the slot plate 18, and a dielectric plate 19 of a low loss dielectric material of Al₂O₃, SiO₂, or Si₃N₄ sandwiched and held between the slot plate 18 and the antenna main body 22.

The radial slot line antenna 25 is attached on the processing vessel 11 through the plasma gas introduction ring 14. A microwave of a frequency of 2.45 GHz or 8.3 GHz is supplied to the radial line slot antenna 25 from an external microwave source (not graphically illustrated) through a coaxial waveguide 21.

The supplied microwave is radiated into the processing vessel 11 from the slots 18a and 18b on the slot plate 18 through the microwave transmission window 17, and excites plasma in the plasma gas supplied from the plasma gas holes 14C in the space 11A immediately below the microwave transmission window 17.

Hermetic sealing is provided between the radial line slot antenna 25 and the plasma gas introduction ring by a seal ring 16B.

Of the coaxial waveguide 21, an outer waveguide 21A is connected to the disk-like antenna main body 22, and a central conductor 21B is connected to the slot plate 18 through an opening formed in the dielectric plate 19. The microwave supplied to the coaxial waveguide 21 is radiated from the slots 18a and 18b while traveling radially between the antenna main body 22 and the slot plate 18.

FIG. 3 shows the slots 18a and 18b formed on the slot plates 18.

Referring to FIG. 3, the slots 18a are arranged concentrically, and the slots 18b perpendicular to their corresponding slots 18a are also formed concentrically. The slots 18a and 18b are formed in the radial direction of the slot plate 18 at intervals corresponding to the wavelength of the microwave compressed by the dielectric plate 19. As a result, the microwave is radiated from the slot plate 18 as a substantially plane wave. At this point, the microwave thus radiated forms a circularly polarized wave including two polarization components perpendicular to each other because the slots 18a and 18b are formed in a mutually perpendicular relationship.

Further, in the plasma processor 10 of FIG. 2, a cooling block 20 having cooling water channels 20A formed thereon is formed on the antenna main body 22. By cooling the cooling block 20 with cooling water in the cooling water channels 20A, heat stored in the microwave transmission window 17 is absorbed through the radial line slot antenna 25.

In the plasma processor 10 according to this embodiment, in the processing vessel 11, the process gas supply part 30 formed of a conductor is provided between the microwave transmission window 17 and the substrate to be processed 12 on the holder 13, being held by part of the exterior wall of the processing vessel 11, so as to oppose the substrate to be processed.

Lattice-like gas diffusion parts 31, inside which a process gas channel 34 into which a process gas is introduced is formed, are provided in the process gas supply part 30. Hole parts 32 of, for instance, a square shape are formed among the gas diffusion parts 31. A process gas is introduced into the gas diffusion parts 31, and diffuses through the lattice-like process gas channel 34. The process gas supply part 30 is formed of a conductive material such as an Al alloy including Mg or Al-added stainless steel.

Multiple gas holes 34A communicating with a space 11B between the process gas supply part 30 and the substrate to be processed 12 from the process gas channel 34 are formed in the gas diffusion parts 31. Each of the gas holes 34A emits the process gas supplied to the process gas channel 34 into the space 11B.

The hole parts 32 are sized so as to let plasma formed in the space 11A pass through from the space 11A to the space 11B efficiently by diffusion. When the process gas is emitted from the gas holes 34A into the space 11B, the emitted process gas is excited by the high-density plasma formed in the space 11A, so that uniform plasma processing is performed with efficiency and at high speed on the substrate to be processed 12, and that without damaging the substrate and a device structure on the substrate or contaminating the substrate. On the other hand, the microwave radiated from the radial line slot antenna 25 is blocked by the process gas supply part 30 formed of a conductor so as to be prevented from damaging the substrate to be processed 12.

The process gas is introduced into the process gas channel 34 through a process gas channel 11c provided in the processing vessel 11. The process gas channel 11c communicates with a process gas channel 14c provided in the plasma gas ring 14. The process gas channel 14c is connected to a process gas supply source (not graphically illustrated) through a process gas introduction part 42, so that a process gas G1 is supplied.

In the case of the plasma processor 10 shown in this embodiment, a large amount of heat flux due to the high-density plasma formed in the space 11A using a microwave is introduced into the process gas supply part 30. Therefore, according to this embodiment, an increase in the temperature of the process gas 30 is suppressed by providing a cooling medium channel 33 cooling the process gas supply part 30.

In the process gas supply part 30, the cooling medium channel 33, in which a cooling medium C2 cooling the process gas supply part 30 flows, is formed inside the process gas diffusion parts 31.

The cooling medium C2 is introduced into the cooling medium channel 33 through a cooling medium channel 11a provided in the processing vessel 11. Further, the cooling medium channel 11a communicates with a cooling medium channel 14a provided in the plasma gas ring 14. A cooling medium mixer 40 is connected to the cooling medium channel 14a, so that the cooling medium C2 is supplied from the cooling medium mixer 40 to the cooling medium channel 33.

The cooling medium mixer 40 is formed of a mixing part 44 and a mist source 45. A cooling gas introduction opening 41A connected to a cooling gas source, not graphically illustrated, is connected to the mixing part 44, so that a cooling gas C1 is supplied.

A H₂O introduction opening 45A connected to a H₂O supply source, not graphically illustrated, is connected to the mist source 45, so that H₂O is supplied to the mist source 45. The mist source 45 generates mist by atomizing the supplied H₂O using, for instance, an ultrasonic wave, and supplies the mist to the mixer 44. In this case, mist means finely granulated liquid H₂O. The mist is mixed with, for instance, a cooling gas, and exists in a liquid state, suspended in the cooling gas.

The mixer 44 generates the cooling medium C2 formed of the cooling gas C1 containing the mist by mixing the mist and the cooling gas C1, and supplies the cooling medium C2 to the cooling medium channel 33 of the process gas supply part 30. Thus, in this embodiment, by using a cooling medium formed by mixing mist into a cooling gas in the case of cooling the process gas supply part 30, it is possible to improve cooling efficiency compared with, for instance, the case of using gas for a cooling medium, and it is possible to suppress an increase in temperature by cooling the process gas supply part 30 with efficiency. This is because the process gas supply part is cooled with efficiency by the mist, existing in a liquid state in the cooling medium C2, removing heat of vaporization when the mist is heated to be evaporated into a gaseous phase.

It has been verified that cooling efficiency is improved by cooling with the cooling medium C2 containing mist according to this embodiment compared with the case of using only a cooling gas without mist. For example, it was confirmed that in the case of using 50 1/min: of air for a cooling gas with introduction of 3 kW of a microwave, the temperature of the process gas supply part was reduced by 25% in the case of adding mist compared with the case of adding no mist.

For example, in the case of forming a fluorinated carbon film (which may be shown as a CₓF_{y} film, but is shown as a CF film in the following description) on the substrate to be processed using Ar as a plasma gas and fluorocarbon-based gas such as C₅F₈ as a process gas, a microwave is introduced by, for example, 2-3 kW.

In this case, the substrate to be processed 12 is maintained at approximately 300°C to 400°C by heating the substrate holder 13 to approximately 300°C to 400°C with a heater. Further, the radial line slot antenna 25, which is cooled by the cooling water channels 20A through the cooling block 20, is maintained at approximately 100°C.

In this case, heat is supplied by radiation from the holding body 13 and the substrate to be processed 12 to the process gas supply part 30, which is further supplied with heat generated by excitation of microwave plasma. Accordingly, a large amount of heat is supplied to the process gas supply part 30. Therefore, in order to cool the process gas supply part 30, it is preferable to increase the amount of cooling by efficient cooling.

In this embodiment, since a cooling medium containing mist is used, cooling efficiency is improved. Accordingly, it is possible to maintain the temperature of the process gas supply part at approximately 100°C to 200°C even under the above-described conditions.

For example, in the case of forming the process gas supply part 30 using Al or an Al alloy, if the temperature of the process gas supply part 30 becomes higher than or equal to 200°C, a problem due to heat, such as deformation of the process gas supply part, may be caused. Accordingly, it is preferable that the temperature of the process gas supply part 30 be set at or below 200°C.

Further, for example, if a film adheres to the process gas supply part 30 as a result of forming a CF film, the film may be removed by plasma cleaning with microwave plasma. Cleaning rate (the rate of etching a CF film) depends substantially on the temperature of the CF film, that is, the temperature of the process gas supply part. For example, in the case of performing plasma cleaning of a CF film using O₂ or H₂ as a cleaning gas, preferably, the temperature of the process gas supply part 30 is set at or above 100°C in order to increase cleaning rate.

Further, for example, in the case of using liquid for a cooling medium, expensive equipment is necessary to maintain the cooling medium at 100-200°C for the above-described reasons. In the case of introducing liquid higher than or equal to 100°C, it may be difficult to ensure the safety of a piping installation for introducing the liquid. Thus, the equipment inevitably becomes expensive and complicated.

Therefore, in this embodiment, it is made possible to improve cooling efficiency of the process gas supply part easily with a simple structure by mixing a cooling gas and mist. Accordingly, it is possible to reduce the cost of cooling the process gas supply part.

The cooling medium that has thus cooled the process gas supply part 30 is discharged from a cooling medium discharge line 41B through a cooling medium channel 11b formed in the processing vessel 11 and a cooling medium channel 14b formed in the plasma gas ring 14.

The gas groove 14B and the cooling medium channels 14a and 14b formed in the plasma gas ring 14 are prevented from communicating with each other.

Further, in this embodiment, in order to increase the cooling efficiency of a cooling medium flowing through the cooling medium channel 33, SF₆, which has low kinematic viscosity, is used as the cooling gas C1 so that the cooling medium enters the state of turbulence with ease. Since SF₆ has low kinematic viscosity, a condition for generation of turbulence is met at low flow rate.

Further, in addition to SF₆, for instance, Ar, He, N₂, and air may be employed as a cooling gas.

Further, if required, it is also possible to use a cooling gas without adding mist thereto. For example, if microwave power is low so that the amount of heat generation is small, it is possible to cool the process gas supply part without adding mist to a cooling medium, using a cooling gas such as SF₆, Ar, He, N₂, or air.

It is also possible to change the position of the process gas supply part 30 by attaching process gas supply part mobilizing means, not graphically illustrated, to the process gas supply part 30. For example, by moving the process gas supply part 30 parallel to the microwave transmission window 17 toward or away from the microwave transmission window 17, it is possible to optimize a distance L1 between the microwave transmission window 17 and the process gas supply part 30 or a distance L2 between the substrate to be processed and the process gas supply part 30. In the case of changing the distance L2, it is also possible to move the holder 13.

In this case, for example, it is possible to optimize the state of microwave plasma excited in the space 11A, and it is possible to optimize substrate processing by optimizing the state of supply of a process gas to the space 11B.

### Second Embodiment

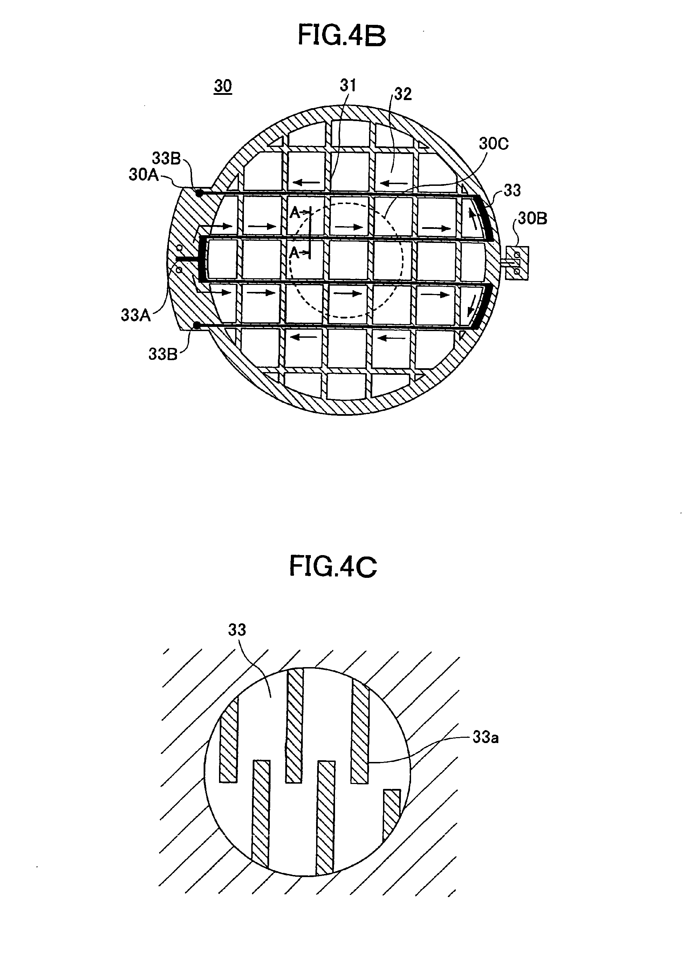

Next, details of the process gas supply part 30 shown in FIG. 2 are shown. FIGS. 4A and 4B show the X-X cross section and the Y-Y cross section, respectively, of the process gas supply part 30 shown in FIG. 2. In the drawings, however, the parts described above are assigned the same reference numerals, and a description thereof is omitted.

Referring first to FIG. 4A, the process gas supply part 30 has the process gas diffusion parts 31 formed like a lattice. Inside the process gas diffusion parts 31, the process gas channel 34 is formed. Between one of the process gas diffusion parts and an adjacent one of the process gas diffusion parts, a corresponding one of the hole parts 32, through which a plasma gas or excited plasma passes, is formed.

Attachment parts 30A and 30B are provided on the process gas supply part 30. The process gas supply part 30 is attached to the processing vessel 11 through the attachment parts 30A and 30B.

The attachment parts 30A and 30B are provided with respective process gas introduction openings 34B, from which a process gas is introduced into the process gas channel 34. Further, the process gas introduction openings 34B communicate with the process gas channel 11c. Graphical illustration of this communication structure is omitted in FIG. 2.

Referring next to FIG. 4B, a cooling medium flows through the cooling medium channel 33 formed in the process gas diffusion parts 31. The cooling medium is introduced from a cooling medium introduction opening 33A provided in the attachment part 30A, flows through the cooling medium channel 33 formed from the attachment part 30A side toward the attachment part 30B side, reverses on the attachment part 30B side to further flow through the cooling medium channel 33 formed toward the attachment part 30A side, and is discharged from cooling medium discharge openings 33B provided in the attachment part 30A.

The cooling medium introduction opening 33A is connected to the cooling medium channel 11a provided in the processing vessel 11. Further, the cooling medium discharge openings 33B are connected to the cooling medium channel 11b. In this drawing, the cooling medium discharge openings 33B are formed on the attachment part 30A side, but may be formed on the attachment part 30B side. They may also be formed on both of the attachment part 30A side and the attachment part 30B side. Any change may be made as required.

Further, it is preferable to provide a structure to increase cooling efficiency to, for instance, part of the process gas supply part 30 where the amount of heating by microwave plasma is particularly large. In this case, the amount of heating by plasma is large and temperature tends to increase around the center part of the process gas supply part 30. Therefore, it is preferable to provide a structure shown in FIG. 4C to the cooling medium channel formed around the center part, for example, in a center part 30C shown in FIG. 4B because this increases cooling efficiency.

FIG. 4C is a cross-sectional view of the process gas diffusion parts 31 shown in FIG. 4B taken along A-A. In this drawing, graphical illustration of those other than the cooling medium channel 33 shown in FIG. 4B is omitted.

Referring to FIG. 4C, in the cooling medium channel 33 shown in this drawing, cooling fins 33a contacting the interior wall surface of the cooling medium channel 33 are formed. Formation of the cooling fins 33a increases an area cooled by a cooling medium, thus resulting in excellent cooling efficiency. Further, for example, by providing such cooling fins in a part where the amount of heating is large, it is possible to achieve excellent uniformity of the temperature of the process gas supply part, and thus to control the effect of deformation due to non-uniformity of the temperature.

### Third Embodiment

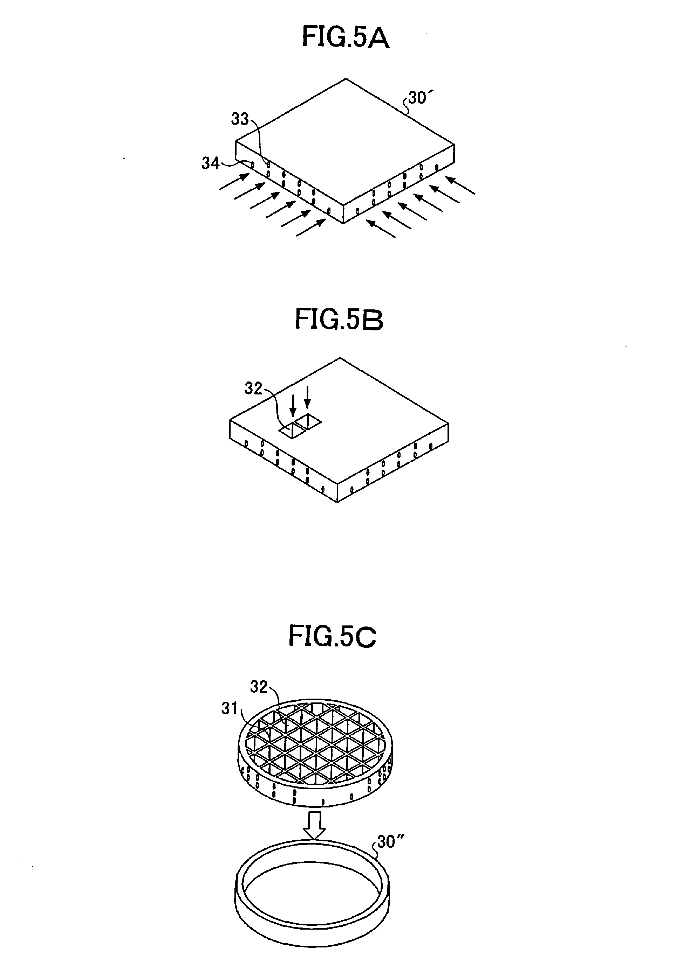

Next, an overview of a method of manufacturing the process gas supply part 30 is shown in FIGS. 5A, 5B, and 5C step by step. In the drawing, however, the parts described above are assigned the same reference numerals, and a description thereof is omitted.

First, in the process shown in FIG. 5A, processing for the cooling medium channel 33 and the process gas channel 34 is performed on a tabular plate 30' formed of, for example, an Al alloy.

With respect to processing for the cooling medium 33 and the process gas channel 34, processing with a gun drill (a drill having greater length in the machining direction than a normal one) is suitable for the case of forming a long hole shape.

Next, in the process shown in FIG. 5B, processing for the hole parts 32 is performed so that holes serving as a passage for plasma or gas are formed, and the lattice-like process gas diffusion parts 31 are formed. Further, processing for the gas holes 34A is performed on the process gas diffusion parts.

Next, in the process shown in FIG. 5C, a plate of a substantially disk-like shape is cut out from the plate 30'. The cut-out plate of a substantially disk-like shape is fitted to a doughnut-like periphery component 30", and electron beam welding is performed on the joint. Further, the attachment parts 30A and 30B are welded, and cleaning is performed if necessary. Thus, the process gas supply part 30 is formed.

Conventionally, in the case of forming, for example, a process gas channel or a cooling medium channel, such a formation method that welds together a component with groove-like processing and the lid part of the component has been employed. In this case, however, there has been a problem in that the processing process becomes complicated so as to increase manufacturing costs. Further, it has been impossible to avoid a problem in that a fine gap where gas or a medium accumulates (an accumulation space) is formed in the process gas channel or cooling medium channel.

In this embodiment, processing is facilitated by forming the cooling medium channel and the process gas channel using a gun drill, thus making it possible to reduce manufacturing costs. Further, it is possible to prevent an accumulation space from being formed in the process gas channel or cooling gas channel and to supply a cooling medium or a process gas with efficiency.

### Fourth Embodiment

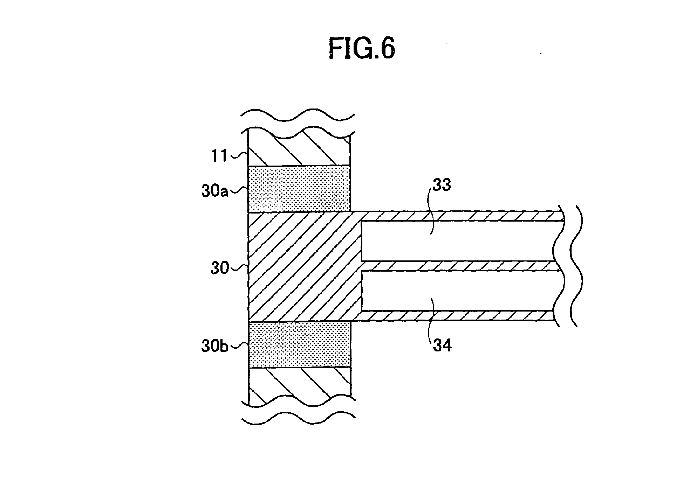

Further, it is preferable that the process gas supply part 30 maintain temperatures of 100-200°C. Accordingly, the process gas supply part 30 preferably has a structure with increased thermal resistance, that is, a heat insulated structure, with respect to the processing vessel 11. Accordingly, it is possible to use the plasma processor 10 with a part thereof to which the process gas supply part 30 is attached being changed as shown in FIG. 6.

FIG. 6 is a cross-sectional view schematically showing a structure of the processing vessel 11 to which the processing gas supply part 30 is attached at greater magnification. In the drawing, however, the parts described above are assigned the same reference numerals, and a description thereof is omitted.

Referring to FIG. 6, the process gas supply part 30 is attached to the processing vessel 11 through heat insulating components 30a and 30b. Therefore, thermal resistance increases between the process gas supply part 30 and the processing vessel 11, thus making it easy to maintain the process gas supply part 30 at 100°C to 200°C.

For example, ceramics (Al2O3, AlN, SiC, etc.) and heat-resisting resin materials (polyimide, etc.) may be used as the material of the heat insulating components 30a and 30b.

### Fifth Embodiment

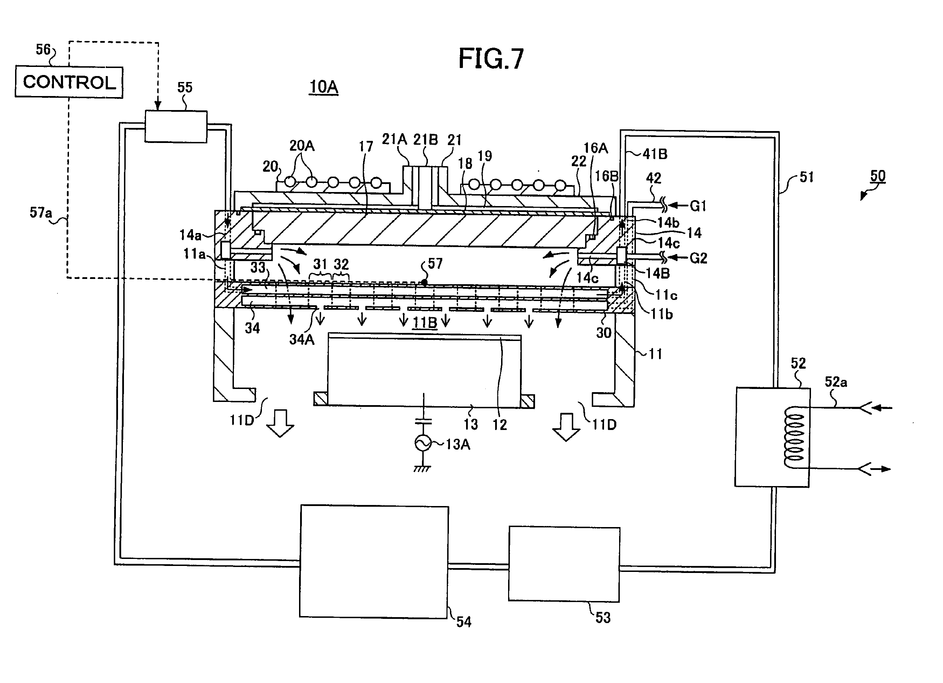

Next, a plasma processor 10A, which is another variation of the plasma processor 10, is shown schematically in FIG. 7. In the drawing, however, the parts described above are assigned the same reference numerals, and a description thereof is omitted.

In this embodiment, a cooling medium circulator 50 circulating a cooling medium discharged from the process gas supply part back again to the process gas supply part is employed. The cooling medium circulator 50 has a cooling medium line 51, cooling means 52, a compressor 53, a reserve tank 54, and cooling medium control means 55.

The cooling medium line 51 is connected to the cooling medium channel 14a and the cooling medium channel 14b, so that the cooling medium discharged from the process gas supply part 30 is circulated back to the process gas supply part 30 through the cooling medium line 51.

The compressor 53 is provided in the cooling medium line 51 so as to enable the cooling medium to be circulated. Further, the reserve tank 54 is provided between the compressor 53 and the process gas supply part 30.

A compressed cooling medium is retained in the reserve tank 54 so that a variation in the flow rate or pressure of the cooling medium to be introduced into the process gas supply part 30 is controlled. As a result, the flow rate or pressure of the cooling medium to be introduced into the process gas supply part 30 is stabilized.

The cooling means 52 is provided in the cooling medium line. For example, a circulating water line 52a is connected to the cooling means 52, so that the cooling medium flowing through the cooling medium line 51 is cooled by circulating water.

According to this embodiment, the cooling medium is circulated and used. Therefore, it is possible to use a cooling gas such as SF₆ by circulating it. Accordingly, the running costs of the processor is reduced compared with the case of emitting a cooling gas to the outside air, and it is possible to control the influence of emission of a cooling gas on the environment.

Further, provision of the cooling means 52 makes it possible to improve the cooling efficiency of the cooling medium by reducing the temperature of the cooling gas.

Further, in this embodiment, it is made possible to control the amount of cooling of the process gas supply part with the cooling medium by providing the cooling medium line 51 further with the cooling medium control means 55. The cooling medium control means 55, which is formed of, for example, flow rate control means such as a mass flow rate controller, makes it possible to control the amount of cooling by the cooling medium by controlling the flow rate of the cooling medium to be introduced into the process gas supply part 30. The cooling medium control means 55 is controlled by a controller 56. Temperature data measured by temperature measurement means 57 provided in the process gas supply part 30 are transmitted to the controller 56 through an interconnection line part 57a. The controller 56 controls the cooling medium control means 55 in accordance with the temperature data, so that the flow rate of the cooling medium is controlled.

For example, in the case of an increase in the temperature of the process gas supply part 30, the controller 56 controls the cooling medium control means 55 in accordance with the temperature data measured by the temperature measurement means 57 so as to increase the flow rate of the cooling medium. Accordingly, the increase in the temperature of the process gas supply part 30 is controlled.

Likewise, in the case of a decrease in the temperature of the process gas supply part 30, the controller 56 controls the cooling medium control means 55 in accordance with the temperature data measured by the temperature measurement means 57 so as to reduce the flow rate of the cooling medium. Accordingly, the decrease in the temperature of the process gas supply part 30 is controlled.

Thus, in this embodiment, it is possible to retain the temperature of the process gas supply part 30 in the range of, for instance, 100°C to 200°C.

Further, the cooling medium control means 55 is not limited to flow rate control means. It is also possible to employ, for example, pressure control means such as a variable conductance valve, which produces the same effect as the flow rate control means.

That is, the controller 56 controls the pressure control means in accordance with the temperature data measured by the temperature measurement means 57. Thereby, the pressure of the cooling medium channel 33 is controlled, so that the amount of cooling of the process gas supply part 30 is controlled. Thus, the temperature of the process gas supply part is controlled. In this case, the higher the pressure of the cooling medium channel 33, the better the cooling efficiency of the cooling medium. The pressure of the cooling medium channel 33 is preferably set to 0.2-1 MPa in order to maintain the amount of cooling.

### Sixth Embodiment

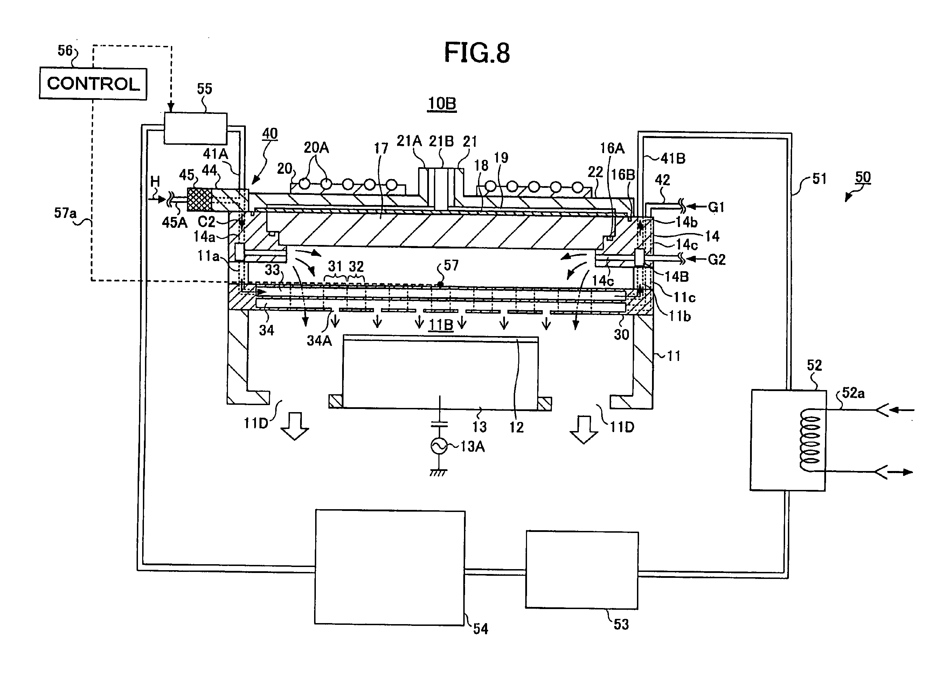

In the fifth embodiment shown in FIG. 7, the cooling medium (cooling gas) is cooled by the cooling means 52, so that the cooling medium mixer 40 in the plasma processor 10 of FIG. 2 is omitted in the structure. Here, further employment of the cooling medium mixer 40 shown in FIG. 2 in the plasma processor 10A as shown next in FIG. 8 makes it possible to achieve a further improvement in cooling efficiency.

FIG. 8 is a schematic diagram showing a plasma processor 10B, which is a variation of the plasma processor 10A shown in FIG. 7. In the drawing, however, the parts described above are assigned the same reference numerals, and a description thereof is omitted.

Referring to FIG. 8, the plasma processor 10B shown in this drawing has a structure where the cooling medium mixer 40 is added to the plasma processor 10A. Therefore, in this embodiment, the same effects as in the case of the plasma processor 10 described in the first embodiment are produced, so that, for example, cooling efficiency is improved. Further, the same effects as the plasma processor 10A described in the fifth embodiment are produced, so that, for instance, the running costs of the processor are reduced.

Further, using the cooling medium mixer 40 and the cooling means 52 in combination further improves cooling efficiency so as to make more remarkable the effect that an increase in the temperature of the process gas 30 is suppressed, thus improving temperature stability.

Further, the cooling method of the cooling means 52 is not limited to the one with cooling water. A variety of methods, for example, heat exchange means such as a heat pump and cooling with other cooling media, are employable.

Further, the shape and the method of forming the cooling medium channel are not limited to the shape shown in this embodiment. In its application, variations and modifications may be made in accordance with a required amount of cooling and in accordance with requirements in apparatus design.

Preferred embodiments of the present invention are described above. However, the present invention is not limited to the above-described specific embodiments, and variations and modifications may be made within the gist recited in CLAIMS.

### INDUSTRIAL APPLICABILITY

According to the present invention, in a plasma processor using microwave plasma, it is possible to increase the cooling efficiency of the process gas supply part of the plasma processor and thereby to suppress an increase in the temperature of the process gas supply part.

Further, it is possible to reduce the cost of cooling the process gas supply part of the plasma processor and thereby to reduce the running costs of the plasma processor.

## Claims

1. A plasma processor, comprising:
a processing vessel having a holder holding a substrate to be processed;
a microwave antenna provided on the processing vessel so as to oppose the substrate to be processed; and
a processing gas supply part provided between the substrate to be processed on the holder and the microwave antenna so as to oppose the substrate to be processed,
**characterized in that** the process gas supply part has a plurality of first openings through which plasma formed in the processing vessel passes, a process gas channel connectable to a process gas source, a plurality of second openings communicating with the process gas channel, and a cooling medium channel through which a cooling medium cooling the process gas supply part flows, wherein the cooling medium includes a cooling gas and mist.

2. The plasma processor as claimed in claim 1, **characterized in that** the cooling medium includes SF₆.

3. A plasma processor, comprising:
a processing vessel having a holder holding a substrate to be processed;
a microwave antenna provided on the processing vessel so as to oppose the substrate to be processed; and
a processing gas supply part provided between the substrate to be processed on the holder and the microwave antenna so as to oppose the substrate to be processed,
**characterized in that** the process gas supply part has a plurality of first openings through which plasma formed in the processing vessel passes, a process gas channel connectable to a process gas source, a plurality of second openings communicating with the process gas channel, and a cooling medium channel through which a cooling medium cooling the process gas supply part flows,
wherein a cooling medium circulator circulating the cooling medium is connected to the cooling medium channel.

4. The plasma processor as claimed in claim 3, **characterized in that** the cooling medium circulator has cooling means for cooling the cooling medium.

5. The plasma processor as claimed in claim 3, **characterized in that** the cooling medium circulator has cooling medium control means for controlling an amount of cooling of the process gas supply part by the cooling medium based on temperature measured by temperature measurement means provided in the process gas supply part.

6. The plasma processor as claimed in claim 5, **characterized in that** the cooling medium control means is flow rate control means for controlling flow rate of the cooling medium.

7. The plasma processor as claimed in claim 5, **characterized in that** the cooling medium control means is pressure control means for controlling pressure of the cooling medium.

8. The plasma processor as claimed in claim 7, **characterized in that** the pressure of the cooling medium channel is set to 0.2-1 MPa.

9. The plasma processor as claimed in claim 3, **characterized in that** the cooling medium includes a cooling gas and mist.

10. The plasma processor as claimed in claim 3, **characterized in that** the cooling medium includes SF₆.
